Europäisches Patentamt

European Patent Office

Office européen des brevets

(11) Veröffentlichungsnummer: **0 344 558 B1**

(12) **EUROPÄISCHE PATENTSCHRIFT**

(45) Veröffentlichungstag der Patentschrift: **02.03.94**

(21) Anmeldenummer: **89109130.8**

(22) Anmeldetag: **20.05.89**

(51) Int. Cl.5: **G01N 27/90**

(30) Priorität: **30.05.88 CH 2043/88**

(43) Veröffentlichungstag der Anmeldung:
**06.12.89 Patentblatt 89/49**

(45) Bekanntmachung des Hinweises auf die
Patenterteilung:
**02.03.94 Patentblatt 94/09**

(84) Benannte Vertragsstaaten:
**AT CH DE FR GB IT LI**

(56) Entgegenhaltungen:
**EP-A- 0 033 802**      **EP-A- 0 152 687**
**EP-A- 0 165 761**      **FR-A- 2 124 952**
**FR-A- 2 570 501**      **GB-A- 1 200 146**
**US-A- 4 573 012**

**ELIN-Zeitschrift 1984,Heft 1/2,Seite 58**

(54) Verfahren und Einrichtung zur Kontrolle von lamellierten Eisenblechpaketen auf Blechschlüsse.

(73) Patentinhaber: **ASEA BROWN BOVERI AG**
**Haselstrasse**
**CH-5401 Baden(CH)**

(72) Erfinder: **Posedel, Zlatimir**
**Hardstrasse 78**
**5432 Neuenhof(CH)**

Anmerkung: Innerhalb von neun Monaten nach der Bekanntmachung des Hinweises auf die Erteilung des europäischen Patents kann jedermann beim Europäischen Patentamt gegen das erteilte europäische Patent Einspruch einlegen. Der Einspruch ist schriftlich einzureichen und zu begründen. Er gilt erst als eingelegt, wenn die Einspruchsgebühr entrichtet worden ist (Art. 99(1) Europäisches Patentübereinkommen).

Rank Xerox (UK) Business Services
(3.10/3.09/3.3.3)

**Beschreibung**

Technisches Gebiet

Die Erfindung bezieht sich auf ein Verfahren zur Kontrolle lamellierter Blechpakete von elektrischen Maschinen auf Blechschlüsse, bei welchem das Blechpaket mittels einer Hilfswicklung magnetisiert wird und die Eisenoberfläche mittels einer Messspulenanordnung mit nachgeschaltetem Messgerät abgetastet wird.

Die Erfindung bezieht sich ferner auf eine Einrichtung zur Durchführung des Verfahrens.

Ausgangspunkt für die Erfindung ist ein Stand der Technik, wie er sich beispielsweise aus der AT-Zeitschrift "ELIN-Zeitschrift" 1984, Heft 1/2, S. 58, Abschnitt 'Eisenschlussortung am Ständerblechpaket', ergibt.

Technologischer Hintergrund und Stand der Technik

Lamellierte Statorblechkörper, insbesondere von elektrischen Maschinen, werden bei der Herstellung und im Betrieb im Zuge von Wartungsarbeiten mit dem Messverfahren der Statorblechringerregung mit Nenninduktion auf Blechschlüsse kontrolliert. Dieses Verfahren, welches die Wirkung von Blechschlussströmen in örtlichen Temperaturunterschieden anzeigt, verlangt eine leistungsstarke und regulierbare Hochspannungsquelle und Erregerwindungen mit grossen Querschnitten.

Bei den Statorblechen mit eingebauten Wicklungsstäben sind mit dieser Kontrolle nur die Fehlerstellen (Kurzschluss mehrerer Bleche untereinander) an der Zahnoberfläche und nicht die Blechfehler im Nutgrund und an den Nutseiten erkennbar. Mit dieser Methode werden nur Blechschlüsse mit einem bestimmten Kontaktwiderstand und resultierenden örtlichen Temperaturunterschieden erkannt, und damit nicht alle Blechschlussstellen. Die Temperaturerhöhung allein reicht nicht für eine quantitative Beurteilung der Blechschlussstelle.

Die Nachteile der konventionellen Eisenblechkontrolle können mit der aus der eingangs genannten Zeitschrift "ELIN..." bekannten Methode der Messung von Blechschlussstromfeldern bei einer schwachen Jochinduktion vermieden werden. Für die Magnetisierung des Blechpakets wird nur ein Niederspannungs-Netzanschluss benötigt. Dabei können praktisch alle Blechschlüsse ermittelt werden, auch solche, die an der Nutwand oder im Nutgrund liegen. Auch lässt sich der Zustand der Blechisolation über die gesamte Bohrungsfläche (auch Nutenfläche) erfassen. Das Eisenpaket kann mit eingebautem Rotor kontrolliert werden. Das bekannte Verfahren ermöglicht eine qualifizierte Analyse der Blechschlussstelle. Die Effizienz einer eventuell durchgeführten Blechreparatur kann sofort leicht kontrolliert werden. Darüber hinaus ermoeglicht das Verfahren den Blechpaketzustands-Vergleich von mehreren Maschinen. Veränderungen am Blechpaket im Laufe der Zeit und Alterungen können festgestellt werden.

Nachteilig dabei ist, dass bei einer Blechpaket-Fehlerstelle die dort abgelesene Messwertanzeige proportional dem Fehlerstrom ("Ursache") ist, nicht aber der im Betrieb auftretenden Uebertemperatur ("Wirkung"). Da aber "Ursache" und "Wirkung" zwar in physikalischem, nicht aber einfach zuordenbarem Zusammenhang stehen, setzt die Interpretation der Messungen einige Erfahrungen voraus. Hierbei ist die Deutung ausgeprägter Messwertanzeigen unproblematisch, da derartige ausgeprägte Messwertanzeigen stets von Fehlern herrühren; schwieriger zu deuten sind diffuse Messwertanzeigen, da es sich hiebei sowohl um "Warmstellen" als auch um Blechpaketinhomogenitäten handeln kann.

Um Messwertanzeigen quantitativ auf die unterschiedlichsten Blechpakettypen zuordnen zu können, wird zu Beginn jeder Messung eine Relativeichung durchgeführt. Kleine Teilbereiche des Blechpaketes werden bei eingeschalteter Erregung oberflächlich kurzgeschlossen ("Eichfehlerstelle") und die Messwertanzeige dabei registriert. Eine Fehleranzeige bei einem tatsächlichen Blechpaketfehler lässt dann aufgrund der vorangegangenen Relativeichung Rückschlüsse auf die tatsächliche Fehlergrösse zu.

Kurze Darstellung der Erfindung

Ausgehend vom Stand der Technik liegt der Erfindung die Aufgabe zugrunde, ein Verfahren zur Kontrolle von lamellierten Eisenblechpaketen auf Blechschlüsse anzugeben, das die geschilderten Nachteile nicht aufweist, eine quantitative Aussage über Lage und Grösse der Schadenstelle ermöglicht, ohne dass vorgängig Relativeichungen an intakten oder Eichfehlerstellen durchgeführt werden müssen.

Aufgabe der Erfindung ist ferner die Bereitstellung einer Einrichtung zur Durchführung des Verfahrens.

Die Lösung dieser Aufgabe erfolgt erfindungsgemäss dadurch, dass mittels eines magnetischen Spannungsmessers, umfassend mindestens zwei elektrisch getrennten, radial distanzierten, aber mechanisch miteinander verbundenen Messspulen, die radiale Verteilung des magnetischen Feldes des Blechschlussstroms aus der Phasendifferenz und/oder der Amplitudenänderung der in den Messspulen induzierten Spannungen ermittelt wird.

Die Verwendung eines Messspulen-Paars im Zusammenhang mit der Untersuchung von Prüflingen ist zwar allgemein bekannt. So wird in der GB-A-1200146 ein Verfahren zur Kontrolle von Bauteilen auf Oberflächenfehler beschrieben, bei welchem das Bauteil von einem Feld senkrecht zur Oberfläche magnetisiert wird. Das Messsystem besteht aus zwei oder mehreren **Spulen mit Eisenkernen,** mit denen Streufelder an der Oberfläche abgetastet werden. Mit dieser Methode können jedoch keine Blechschlussströme (Schlingströme zwischen benachbarten Blechen) erzeugt oder gemessen werden. Das bekannte Verfahren setzt ein homogenes Bauteil voraus, das Fehlstellen oder Imhomogenitäten aufweisen kann, die es zu detektieren gilt. Ein Blechkörper einer elektrischen Maschine hingegen besteht sozusagen nur aus "Inhomogenitäten", nämlich geschichteten und im Idealfall voneinander perfekt isolierten Blechen. Fehlstellen dieser Iolierung führen zu Blechschlussströmen, die es hinsichtlich ihrer Lage zu detektieren gilt.

Die zugehörige Einrichtung zur Durchführung des Verfahrens umfasst eine Hilfsspule zur Aufmagnetisierung des Blechpakets, eine Messsonde mit zwei elektrisch getrennten, mechanisch miteinander verbundenen Messspulen, einen an die Messspule angeschlossenen Messeinrichtung zur Erfassung der Phasenwinkelabweichungen und/oder Amplitudenänderungen der in den Messspulen induzierten Spannungen, und eine nachgeschaltete Registriereinheit.

Die Erfindung wird nachstehend anhand der Zeichnung näher erläutert.

Kurze Beschreibung der Zeichnung

In der Zeichnung zeigt

Fig. 1     eine Prinzipskizze zur Verdeutlichung der Ringerregung eines Statorblechpaketes;
Fig. 2     eine Prinzipskizze zur Veranschaulichung der Lage der Messspulen;
Fig. 3     einen Schnitt durch die Messanordnung an zwei Statorzähnen mit zugehörigem Vektordiagramm bei intaktem Blechpaket;
Fig. 4     eine Anordnung analog Fig. 3 mit einem Blechschluss;
Fig. 5     eine Anordnung zur Erzeugung von Referenzsignalen mit zugehörigem Vektordiagramm;
Fig. 6     eine schematische Darstellung der Messanordnung samt deren Blockschaltbild;
Fig. 7     ein Diagramm, das den Verlauf der Phasendifferenz wiedergibt.

Detaillierte Beschreibung der Erfindung

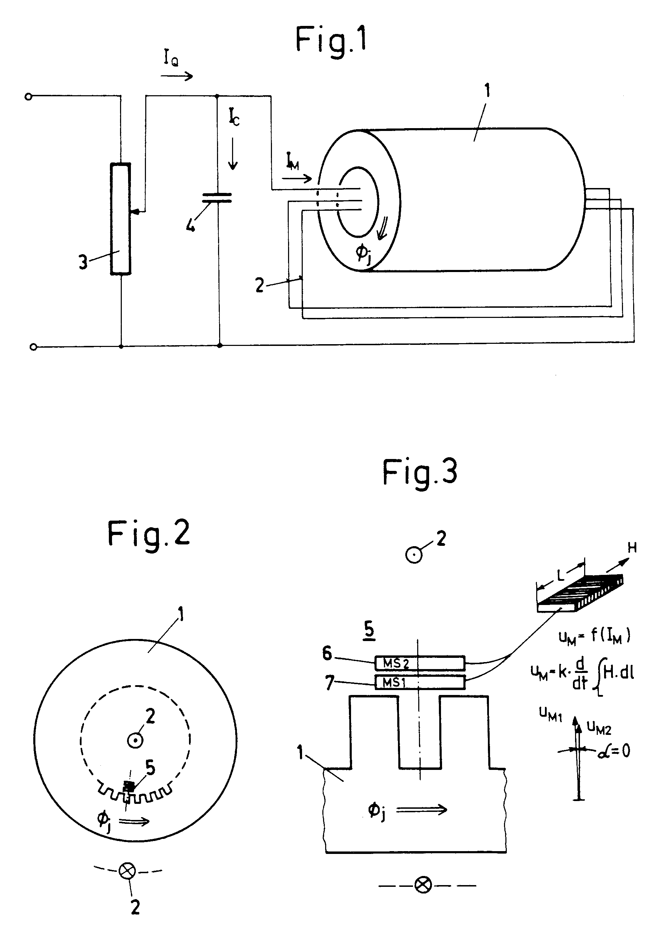

Ein Statorblechpaket 1 einer elektrischen Maschine wird mit einer Ringerregung wie bei der traditionellen Messung mittels einer um das Statorblechpaket gelegten Spule 2 schwach magnetisiert (Fig. 1). Bei dieser Messung beträgt die Jochinduktion nur ca. 5-10% der Nenninduktion. Für die Einspeisung der Induktionsspule genügt das Niederspannungsnetz. Die Ringmagnetisierung erfolgt vorzugsweise über einen Autotransformator 3 mit einstellbarer Ausgangsspannung (Variac) aus dem Niederspannungsnetz. Durch Kompensation des induktiven Blindstromes mittels parallelgeschaltetem Kondensator 4 ergibt sich die Möglichkeit einer Verringerung des Einspeisungsstrome $I_Q$. Der maximale Speisestrom beträgt bei diesen Messungen ca. 20A.

Gegenüber der traditionellen Eisenblechkontrolle mit Nennjochinduktion, die die Erwärmung der Blechschlüsse ("Hot spots") registriert (Infrarotkamera, Handabtastung), wird bei dieser Methode an der Eisenblechpaketoberfläche mit einer Spulenanordnung 5, umfassend zwei Messspulen 6,7, die miteinander starr verbunden, jedoch radial voneinander distanziert sind, die radiale Verteilung des magnetischen Feldes eines Blechschlussstromes ermittelt (Fig. 2 und 3) Die an den Enden der Messspulen 6,7 gemessene Spannungen $U_{M1}$ $U_{M2}$ eines blechschlussfreien Eisenpaketes sind proportional dem magnetischen Potential zwischen den Spulenenden oder dem Magnetisierungsstrom. Die Messspulen dienen somit als magnetischen Spannungsmesser ("Rogowski Spule") des Linienintegrals zwischen den Endpunkten der Messspulen. Der Winkel zwischen den induzierten Messspulenspannungen ist Null (Fig. 3). Bei einem Blechschluss 8 wird der Fehlerstrom $I_F$ über die kurzgeschlossenen Bleche in den Messspulen 6,7 unterschiedliche, in der Phase verschobene Spannungen induzieren.

$$U_r = \frac{w}{l} \cdot \int_L d\ell \cdot \frac{d}{dt} \cdot \iint_A \vec{B_r} \cdot dA$$

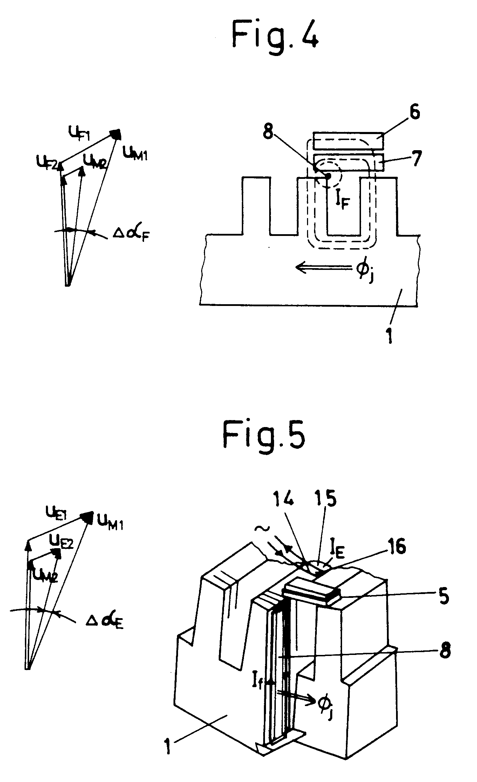

Die Messspulen 6,7 sind für den Fehlerstrom die Induktionsspulen, die in der radialen Richtung des Blechpakets unterschiedliche magnetische Induktionen $B_F$ des Fehlerstromes messen. Dadurch entsteht bei einem Blechschluss 8 eine Phasenverschiebung $\Delta\alpha$ zwischen den Spannungen der Messspulen 6,7 (Zeigerdiagramme in Fig. 4 und 5).

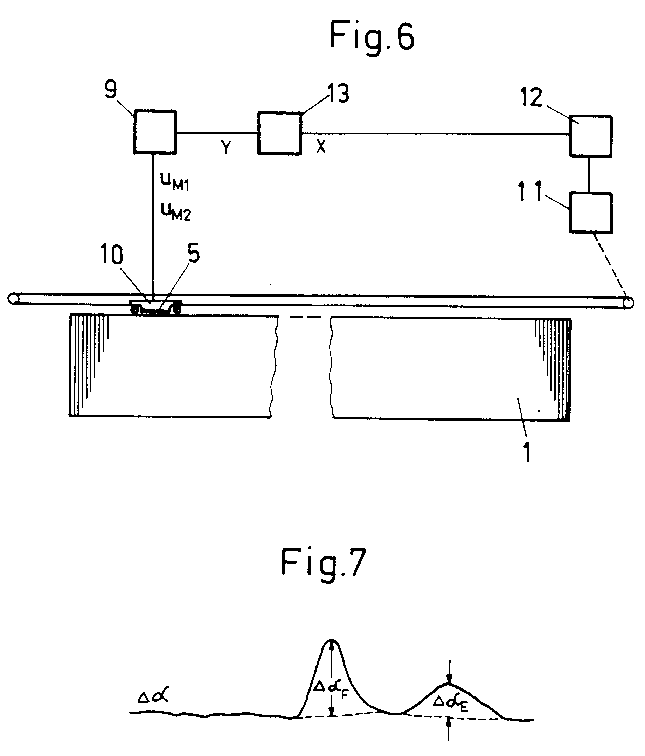

Die vom Fehlerstrom verursachten Phasenverschiebungen der Messspannungen sind von der Grösse und der Streckenlänge des Blechschlussstromes abhängig. Die Spannungen der Messpulen 6,7 werden verstärkt und mit einem Phasendetektor 9 wird die Phasenwinkelabweichung $\Delta\alpha$ der Messspannungen und/oder die Amplitudenänderung $\Delta\phi$ ermittelt (Fig. 6).

Die vorzugsweise in einem fahrbaren Träger 10 eingebauten Messspulen 6,7 bewegen sich mittels Seiltrieb und eines Antriebsmotors 11 entlang der Nuten von einem Ende bis zum anderen Endes des Eisenblechpakets 1. Ein mit dem Antriebsmotor 11 gekuppelter Dreh- oder Weggeber 12 erlaubt es, die axiale Position des Trägers und damit der Messspulenanordnung 5 zu erfassen.

Die durch Blechströme hervorgerufenen Phasenabweichungen $\Delta\alpha$, und/oder Amplitudenänderungen $\Delta\phi$ der Messspannungen werden mit einem X-Y schreiber 13, als eine Serie von Linien, eine für jede Nut, registriert.

Die registrierten Signale entlang der Nuten werden mit den Signalen, die den Blechströmen entsprechen, verglichen. Eine Schleife 14 aus einem dünnen Leiter mit der Breite des Blechschlusses 16 wird an den Zahnoberfläche 15 befestigt und mit einem dem Blechschlussstrom entsprechenden Strom gespeist (Fig. 5).

Die Einspeisung des Blechschlussstromes erfolgt über den Autotransformator 3 aus dem Netz. Die Blechschlussströme von kurzgeschlossenen Blechen sind aus den bekannten Spannungswerten zwischen den Blechen und der Impedanz der einzelnen Bleche definiert. Das Signal der Messspulen ($\Delta\alpha$) wird dann mit und ohne diesen Schleifenstrom registriert ($\Delta\alpha_E$) und mit dem des Blechschlussstromes ($\Delta\alpha_F$) verglichen (Fig. 7).

Anstelle eines Seiltriebes kann der Träger auch als flache Selbstfahr-Lafette ausgebildet werden, wobei entsprechend Fig.6 deren Antriebsmotor mit einem Weg- oder Umdrehungsgeber zur Erfassung des zurückgelegten Weges gekuppelt ist.

Das beschriebene Verfahren ermöglicht bei elektrischen Maschinen eine Statorblechkontrolle auch mit eingebautem Rotor. Dabei muss der Rotor einer Seite der Maschine vollständig gegen Erde isoliert sein, was bei grossen Generatoren üblich ist.

Eine auf beiden Maschinenseiten nicht isolierte Welle wäre wie eine sekundär kurzgeschlossene Wicklung, in welcher wegen guter magnetischer Koppelung einige hundert Ampere bei schwacher Erregung fliessen können. Eine nicht vorhandene Isolation der Welle auf einer Maschinenseite ist durch die Messung des Wellenstromes mit einer Rogowski Spule und Wellenspannung gegen Erde am nichtantriebsseitigen Ende der Maschine und durch starke Erhöhung der für die Magnetisierung des Statorpakets benötigen Amperewindungen bemerkbar.

Die Aufmagnetisierung des Statorpakets bei maschinen mit eingebautem Rotor, insbesondere bei grossen Turbomaschinen, erfolgt deshalb vorzugsweise aus einer stromstarken Speisequelle, die zwischen beiden Maschinenseiten an der isolierten Welle angeschlossen ist.

**Patentansprüche**

1. Verfahren zur Kontrolle lamellierter Blechpakete (1) von elektrischen Maschinen auf Blechschlüsse, bei welchem das Blechpaket (1)mittels einer Hilfswicklung (2) magnetisiert und die Eisenoberfläche mittels einer Messspulenanordnung (MS1,MS2) mit nachgeschaltetem Messgerät (9) abgetastet wird, dadurch gekennzeichnet, dass mittels eines magnetischen Spannungsmessers, mit mindestens zwei elektrisch getrennten, radial distanzierten, aber mechanisch miteinander verbundenen Messspulen (6,7), die radiale Verteilung des magnetischen Feldes des Blechschlussstromes (IF) aus der Phasendifferenz und/oder der Amplitudenänderung der in den beiden Messspulen (6,7) induzierten Spannungen (UM1,UM2) ermittelt wird.

**2.** Verfahren nach Anspruch 1, dadurch gekennzeichnet, dass die Phasenabweichung ($\Delta\alpha$) der Signale der Messspulen (6,7) über einen Phasendetektor (9) ermittelt wird.

**3.** Verfahren nach Anspruch 1, dadurch gekennzeichnet, dass der Amplitudenunterschied ($\Delta\phi$) der Signale der Messspulen (6,7) mit einem Registriergerät (13) erfasst wird.

**4.** Verfahren nach einem der Ansprüche 1-3, dadurch gekennzeichnet, dass die registrierten Signale mit Signalen, die den Blechschlussströmen entsprechen, verglichen werden, wobei eine Schleife (14) mit entsprechender Breite an der Eisenblechfläche (15) befestigt und mit entsprechendem Blechschlusstrom gespeist wird.

**5.** Verfahren nach einem der Ansprüche 1-4, dadurch gekennzeichnet, dass die Messspulen (6,7) auf einem Träger (10) angeordnet sind und mittels eines Antriebsmotors (11) entlang des Eisenpakets (1) von einem Ende bis zum anderen Ende bewegt werden.

**6.** Verfahren nach einem der Ansprüche 1-5, dadurch gekennzeichnet, dass die Aufmagnetisierung des Eisenpakets (1) über die Rotorwelle aus einer stromstarken Speisequelle, die zwischen beiden Maschinenscheiten an der isolierten Welle angeschlossen ist, erfolgt.

**7.** Einrichtung zur Durchführung des Verfahrens nach Anspruch 1, gekennzeichnet durch eine Hilfsspule (2) zur Aufmagnetisierung des Blechpakets (1), eine Messspulenanordnung (5) mit zwei elektrisch getrennten, mechanisch miteinander verbundenen Messspulen (6,7), eine an die Messspulen angeschlossene Messeinrichtung (9) zur Erfassung der Phasenwinkelabweichung und/oder Amplitudenänderungen der in den Messspulen induzierten Spannungen (UM1, UM2) sowie eine an die Messeinrichtung angeschlossene Registriereinheit (13).

**Claims**

**1.** Method for testing laminated cores (1) of electrical machines for cross-over shorts, in which the laminated core (1) is magnetized by an auxiliary coil (2) and the iron surface is probed by an assembly of measuring coils (MS1, MS2) connected to a meter (9), characterized in that a fluxgate magnetometer, comprising at least two electrically separated, radially spaced apart, but mechanically joined measuring coils (6, 7), is used to determine the radial distribution of the magnetic field due to the cross-over short-circuit current (IF) from the phase difference and/or the amplitude variation of the voltages (UM1, UM2) induced in the two measuring coils (6, 7).

**2.** Method according to Claim 1, characterized in that the phase deviation ($\Delta\alpha$) of the signals from the measuring coils (6, 7) is determined by a phase detector (9).

**3.** Method according to Claim 1, characterized in that the amplitude difference ($\Delta\phi$) of the signals from the measuring coils (6, 7), is detected by a recording device (13).

**4.** Method according to one of Claims 1-3, characterized in that the recorded signals are compared with signals corresponding to cross-over short-circuit currents, whereby a loop (14) of the sheet width is fixed on the iron laminate surface (15) and fed with the corresponding cross-over short-circuit current.

**5.** Method according to one of Claims 1-4, characterized in that the measuring coils (6, 7) are arranged on a mount (10) and transported by a drive motor (11) along the iron laminated core (1) from one end to the other.

**6.** Method according to one of Claims 1-5, characterized by the magnetization of the iron laminated core (1) being carried out by connecting through the rotor shaft a high-current supply across the insulated shaft between the two sides of the machine.

**7.** Device for the implementation of the method according to Claim 1, characterized by an auxiliary coil (2) for magnetization of the laminated core (1), a measuring coil assembly (5) with two electrically separate, mechanically joined measuring coils (6, 7), a meter (9) connected to the measuring coils which serves to detect the phase-angle deviation and/or amplitude variations of the voltages (UM1

5

UM2) induced in the measuring coils, as well as a recorder (13) connected to the meter.

**Revendications**

1. Procédé pour le contrôle d'empilements de tôles feuilletés (1) de machines électriques pour détecter les contacts entre des tôles, dans lequel l'empilement de tôles (1) est magnétisé au moyen d'un enroulement auxiliaire (2 et où la surface de fer est scrutée au moyen d'un agencement de bobines de mesure (MSI, MS2) suivi d'un appareil de mesure (9), caractérisé en ce qu'au moyen d'un voltmètre magnétique, comprenant au moins deux bobines de mesure (6, 7) électriquement distinctes, radialement distantes mais mécaniquement reliées l'une à l'autre, la distribution radiale du champ magnétique du courant de contact entre tôles (1F) est déterminée à partir de la différence de phase et/ou de la variation d'amplitude des tensions (UMI, UM2) induites dans les deux bobines de mesure (6, 7).

2. Procédé suivant la revendication 1, caractérisé en ce que l'écart de phases ($\Delta\alpha$) des signaux des bobines de mesure (6, 7) est déterminé au moyen d'un détecteur de phase (9).

3. Procédé suivant la revendication 1, caractérisé en ce que la différence d'amplitude ($\Delta\phi$) des signaux des bobines de mesure (6, 7) est déterminée avec un appareil enregistreur (13).

4. Procédé suivant l'une quelconque des revendications 1 à 3, caractérisé en ce que les signaux enregistrés sont comparés avec des signaux qui correspondent aux courants de contact entre tôles, une boucle (14) de largeur appropriée étant fixée à la surface de tôle de fer (15) et étant alimentée avec un courant de contact entre tôles correspondant.

5. Procédé suivant l'une quelconque des revendications 1 à 4, caractérisé en ce que les bobines de mesure (6, 7) sont disposées sur un support (10) et sont déplacées au moyen d'un moteur de commande (11) le long de l'empilement de fer (1) d'une extrémité à l'autre extrémité.

6. Procédé suivant l'une quelconque des revendications 1 à 5, caractérisé en ce que la magnétisation de l'empilement de fer (1) est réalisée via l'arbre du rotor à partir d'une source d'alimentation à courant fort, qui est raccordée à l'arbre isolé entre les deux côtés de la machine,

7. Dispositif pour la mise en oeuvre du procédé suivant la revendication 1, caractérisé par une bobine auxiliaire (2) pour la magnétisation de l'empilement de tôles (1), un agencement (5) de bobines de mesure avec deux bobines de mesure (6, 7) électriquement distinctes et mécaniquement reliées l'une à l'autre, un dispositif de mesure (9) raccordé aux bobines de mesure pour déterminer les écarts angulaires de phase et/ou les variations d'amplitude des tensions (UMI, UM2) induites dans les bobines de mesure, ainsi qu'une unité d'enregistrement (13) raccordée au dispositif de mesure.

# Fig.1

$I_Q$

$I_C$

$I_M$

1

$\phi_j$

3

4

2

# Fig.3

$\odot$ 2

5

6  MS2

7  MS1

1

$\phi_j$

H

L

$u_M = f(I_M)$

$u_M = k \cdot \dfrac{d}{dt} \displaystyle\int H \cdot dl$

$u_{M1}$

$u_{M2}$

$\alpha = 0$

$--\otimes---$

# Fig.2

1

2

5

$\phi_j$

$\otimes$

2

# Fig.4

# Fig.5

## Fig.6

## Fig.7